**Europäisches Patentamt**

(19) **European Patent Office**

**Office européen des brevets**

(11) Numéro de publication: **0 052 536 B1**

(12) **FASCICULE DE BREVET EUROPEEN**

(45) Date de publication du fascicule du brevet: 08.08.84

(51) Int. Cl.³: **H 04 B 9/00**

(21) Numéro de dépôt: **81401584.8**

(22) Date de dépôt: **13.10.81**

(54) Dispositif de stabilisation de la puissance de sortie d'un module émetteur pour système de transmission sur fibre optique.

(30) Priorité: **14.11.80 FR 8024230**

(43) Date de publication de la demande: **26.05.82 Bulletin 82/21**

(45) Mention de la délivrance du brevet: **08.08.84 Bulletin 84/32**

(84) Etats contractants désignés: **CH DE GB LI**

(56) Documents cités:
FR - A - 2 448 274
GB - A - 1 539 624

2ème COLLOQUE EUROPEEN SUR LES TRANSMISSIONS PAR FIBRES OPTIQUES, Paris, 27-30 septembre 1976, Tour Olivier de Serres Paris, FR R.E. EPSWORTH: "Sous-ensembles pour liaisons optiques à grande vitesse", pages 377-382
5th EUROPEAN CONFERENCE ON OPTICAL COMMUNICATION, 17-19 septembre 1979 Amsterdam, NL E. DUDA: "Semiconductor laser transmitter for optical communication systems", pages 13-5-1 à 13-5-4
IEEE TRANSACTIONS ON COMMUNICATIONS, vol. COM-26, juillet 1978, no. 7 New York, US J. GRUBER et al.: "Electronic circuits for high bit rate digital fiber optic communication systems", pages 1088-1098

(73) Titulaire: **LIGNES TELEGRAPHIQUES ET TELEPHONIQUES L.T.T., 1, rue Charles Bourseul, F-78702 Conflans-Ste-Honorine (FR)**

(72) Inventeur: **Roullet, Gerald, THOMSON-CSF SCPI 173, bld Haussmann, F-75360 Paris Cedex 08 (FR)**
Inventeur: **Breton, Jean-Paul, THOMSON-CSF SCPI 173, bld Haussmann, F-75360 Paris Cedex 08 (FR)**
Inventeur: **Maclaszek, Adalbert, THOMSON-CSF SCPI 173, bld Haussmann, F-75360 Paris Cedex 08 (FR)**

(74) Mandataire: **Benoit, Monique et al, THOMSON-CSF SCPI 173, Bld Haussmann, F-75379 Paris Cedex 08 (FR)**

(56) Entgegenhaltungen: (Fortsetzung)
ELECTRONICS LETTERS, vol. 16, no. 1, janvier 1980 Londres, GB F.S. CHEN: "Simultaneous feed-back control of bias and modulation currents for injection lasers", pages 7 et 8
WIRELESS WORLD, vol. 82, no. 1492, décembre 1976 Londres, GB M. RAMSAY et al.: "Optical fibre communication - 2", pages 67-70

## Description

La présente invention se rapporte d'une manière générale aux systèmes de transmission sur fibre optique et concerne plus particulièrement un dispositif de stabilisation de la puissance optique de sortie du module émetteur pour un système de transmission d'informations, notamment à débit élevé, par exemple égal à 140 Mbit/s.

D'une manière générale, pour un système de transmission sur fibre optique, le module émetteur comporte une embase émettrice constituée d'une diode laser, d'une photodiode de contrôle et d'une optique de couplage laser-fibre insérée dans une fiche de connecteur pour le raccordement de ladite embase au câble à fibre optique, et une électronique de commande assurant entre autres une régulation ou stabilisation de la puissance optique émise.

D'autre part, on sait qu'en présence d'informations à transmettre, le courant de la diode laser utilisée dans le module émetteur résulte de la superposition de son courant continu de polarisation et de son courant de modulation, de sorte que l'amplitude des impulsions lumineuses transmises dans la fibre optique dépend de la puissance optique émise par la diode laser. Comme on souhaite transmettre les impulsions lumineuses à la puissance maximale de sortie de la diode laser, il s'avère nécessaire de stabiliser à la fois la puissance optique maximale et la puissance optique minimale, de façon à maintenir constante l'amplitude de la puissance optique émise par la diode laser; cette stabilisation est obtenue en effectuant une régulation du courant de modulation de la diode laser. De plus, lorsque la température du boîtier renfermant la diode laser varie, la caractéristique de transfert de la diode laser (puissance de sortie en fonction du courant) est modifiée, de sorte qu'une régulation du courant continu de polarisation de la diode laser en fonction de la température permet une détection sur le vieillissement de la diode laser, identique dans la gamme des températures d'utilisation.

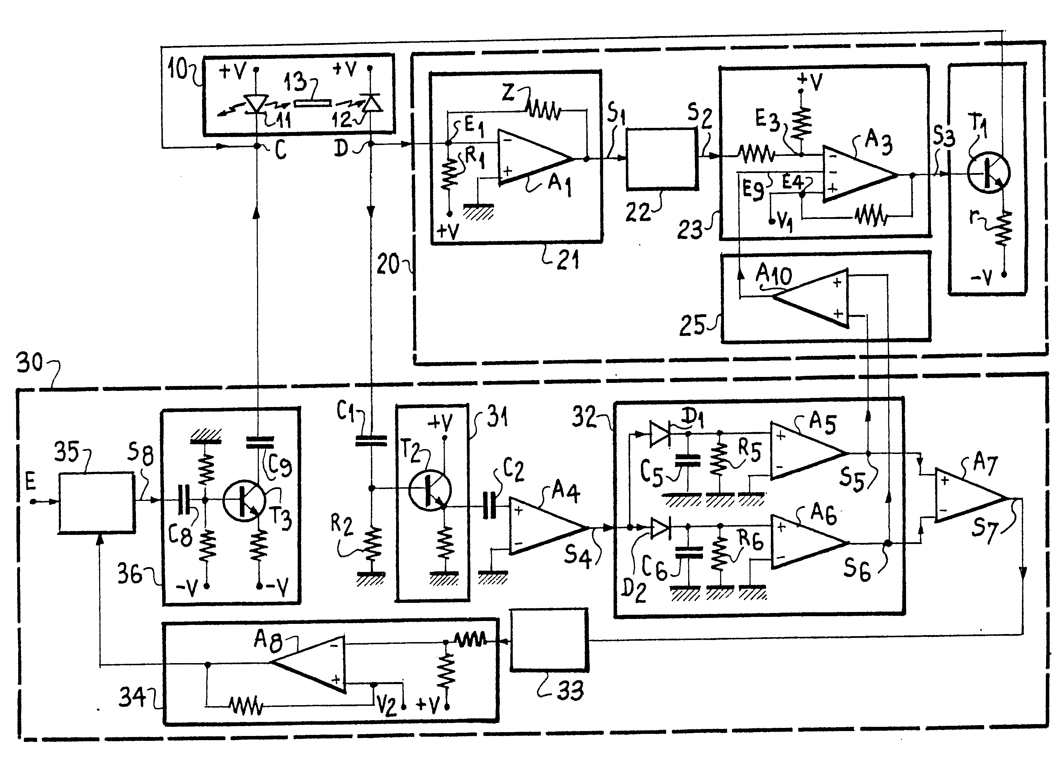

Pour un système de transmission d'informations à débit élevé, on connaît un dispositif permettant de stabiliser la puissance optique émise par la diode laser utilisée dans le module émetteur, tel que décrit dans l'article publié dans la revue »IEEE TRANSACTIONS ON COMMUNICATIONS«, vol. 26, N° 7, Juillet 1978, pages 1088 à 1097, intitulé: »Electronic Circuits for High Bit Rate Digital Fiber Optic Communication System«. Selon la fig. 8 de cet article, le dispositif de stabilisation de la puissance optique émise par la diode laser comporte une première boucle d'asservissement comprenant un détecteur crête à crête du signal de modulation, en série avec un différenciateur, permettant de stabiliser la puissance optique maximale et la puissance optique minimale émises par la diode laser, maintenant ainsi constante l'amplitude de la modulation de la puissance optique émise, et une seconde boucle d'asservissement comprenant un amplificateur continu en série avec un différenciateur, permettant de stabiliser la tension continue de polarisation de la diode laser correspondant à la puissance optique minimale émise par ladite diode.

Cependant, un tel dispositif de stabilisation de la puissance optique émise par une diode laser présente des inconvénients. En effet, en l'absence d'informations numériques, on est obligé de mettre simultanément hors service les deux boucles d'asservissement. De plus, en raison de la stabilisation de la tension de polarisation de la diode laser à une valeur correspondant à la puissance optique minimale émise par ladite diode, ce dispositif ne peut transmettre ni des informations analogiques ni des informations en codes multiniveaux. En outre, la structure de ce dispositif est relativement complexe.

Pour permettre une transmission d'informations quelconques, c'est-à-dire numériques, analogiques ou à codes multiniveaux, à débit élevé, il est connu de réaliser la stabilisation de la puissance optique émise par une diode laser à l'aide d'un dispositif du même type que celui décrit précédemment mais qui consiste, outre à stabiliser l'amplitude de la modulation de la puissance optique émise par la diode, à stabiliser désormais la valeur moyenne de la puissance optique émise correspondant à la tension continue de polarisation de la diode laser, comme cela est décrit par exemple dans l'article publié dans la revue »Wireless World«, vol. 82, n° 1492, décembre 1976, pages 67 à 70, intitulé: »Optical fibre communication — 2«.

Toutefois, il s'avère qu'un tel dispositif de stabilisation de la puissance optique est limité en basse fréquence et qu'on observe dès lors le phénomène suivant, pour des informations transmises à débit élevé et par exemple numériques.

D'une part, en présence d'une prépondérance d'états logiques »1«, la diode laser n'est plus polarisée au-dessus du seuil pour les états logiques »0«. Dans ce cas, il apparaît le phénomène dit de retard à l'émission stimulée de la diode laser, comme connu en soi.

D'autre part, en présence d'une prépondérance d'états logiques »0«, le courant injecté dans la diode laser, correspondant aux états logiques »1«, est trop important et dégrade ladite diode laser.

La présente invention a pour but de remédier à ces difficultés en proposant un dispositif de stabilisation de la puissance optique émise par une diode laser, qui est d'une structure très simple, permet de restituer la composante basse fréquence du spectre du signal à transmettre, assure un fonctionnement correct de la diode laser (absence de surintensités, et absence de retard à l'émission stimulée), et peut être réalisé sous forme d'un circuit hybride, ce qui en abaisse notablement le coût de réalisation.

A cet effet, l'invention a pour objet un dispositif de stabilisation de la puissance de sortie d'un module émetteur pour un système de transmission d'informations utilisant une fibre optique et comportant:

— un ensemble dans lequel sont disposés une diode laser, des moyens de prélèvement d'une partie de la puissance optique émise par la diode laser et de conversion en puissance électrique;

— un premier circuit de stabilisation de la valeur moyenne de la puissance optique émise par la diode laser connecté entre les moyens de conversion et la diode laser, et comportant des premiers moyens comparateur de tension engendrant une tension continue stabilisée de polarisation de la diode laser correspondant à la valeur moyenne de la puissance optique émise par la diode laser; et

— un second circuit de stabilisation de l'amplitude de modulation de la puissance optique émise par la diode laser connecté entre les moyens de conversion et la diode laser et comportant des moyens de détection crête à crête du signal de modulation de la diode laser et des moyens de différenciation des signaux engendrés par les moyens de détection crête à crête fournissant un signal de modulation de la diode laser ayant une amplitude crête à crête stabilisée correspondant à la différence entre la puissance optique maximale et la puissance optique minimale émises par la diode laser; caractérisé en ce que le premier circuit de stabilisation de la valeur moyenne de la puissance optique émise par la diode laser comporte de plus des moyens de restitution de la composante basse fréquence du signal à transmettre connectés entre la sortie des moyens de détection crête à crête et l'entrée des premiers moyens comparateur de tension, permettant ainsi de stabiliser les valeurs minimale et maximale de la puissance optique émise par la diode laser.

D'autres caractéristiques et avantages de l'invention apparaîtront mieux dans la description détaillée qui suit et se réfère à l'unique dessin annexé, donné uniquement à titre d'exemple et qui est un schéma partiellement sous forme électrique du module émetteur comportant le dispositif de stabilisation de puissance selon l'invention.

On notera dès à présent que toutes les tensions d'alimentation repérées par V sur le dessin sont de l'ordre de 12 volts.

Suivant un exemple de réalisation et en se reportant au dessin annexé, le module émetteur d'un système de transmission d'informations, notamment à débit élevé, par exemple égal à 140 Mbits/s, sur fibre optique, comprend un ensemble 10 réalisé sous forme d'un boîtier dans lequel sont disposées une diode laser 11 dont la puissance optique émise est injectée dans la fibre (non représentée), des moyens de prélèvement d'une partie de la puissance optique émise par la diode laser et de conversion en puissance électrique constitués par exemple par une photodiode 12, et une fibre de couplage 13 entre la diode laser 11 et la photodiode 12.

Le dispositif de stabilisation de la puissance optique de sortie de la diode laser 11 utilisée dans le module émetteur comporte un premier circuit 20 de stabilisation de la valeur moyenne de la puissance optique émise par ladite diode connecté entre la photodiode 12 et la diode laser 11, et un second circuit 30 de stabilisation de la puissance optique maximale et de la puissance optique minimale émises par ladite diode, correspondant à une stabilisation de l'amplitude de modulation de la puissance optique émise, connecté entre la photodiode 12 et la diode laser 11.

Comme on le voit bien sur la figure, le premier circuit 20 de stabilisation de la valeur moyenne de la puissance optique émise par la diode laser 11 comporte un convertisseur courant-tension 21 constitué par un amplificateur opérationnel $A_1$, monté en transimpédance dont une entrée $E_1$ est connectée à la photodiode 12. On a représenté en Z l'impédance de contre-réaction connectée entre la sortie $S_1$ et l'entrée $E_1$ de l'amplificateur opérationnel $A_1$, et en $R_1$ la résistance de charge de cet amplificateur. Ainsi, le courant engendré par la photodiode 12, proportionnel à la puissance optique émise par la diode laser 11, est converti en une tension par l'amplificateur monté en transimpédance $A_1$. Le signal en sortie $S_1$ est ensuite intégré par un filtre passe-bas 22 de structure classique connecté en série avec le convertisseur courant-tension 21. Le filtre passe-bas 22 fournit à sa sortie $S_2$ une tension continue proportionnelle à la puissance optique moyenne émise par la diode laser 11. Cette tension est ensuite présentée à un circuit comparateur de tension 23 constitué par un amplificateur opérationnel $A_3$ ayant une première entrée $E_3$ reliée à la sortie du filtre passe-bas 22, et une seconde entrée $E_4$ reliée à une source de tension de référence $V_1$ correspondant à la puissance optique moyenne émise par la diode laser 11. On expliquera par la suite le rôle précis du circuit comparateur de tension 23. On notera dès à présent que le comparateur de tension 23 fournit en sortie $S_3$ une tension destinée à polariser la diode laser 11 à sa puissance optique moyenne. A cet effet, cette tension commande la base d'un transistor $T_1$ de polarisation de la diode laser 11, le collecteur du transistor $T_1$ étant relié en C à la diode laser 11, et une résistance r étant reliée à l'émetteur dudit transistor afin de limiter le courant injecté.

Comme il apparaît sur la figure, le second circuit 30 de stabilisation de l'amplitude de modulation de la puissance optique émise par la diode laser 11, comporte un circuit adaptateur d'impédance 31 constitué d'un transistor $T_2$ dont la base est reliée, par l'intermédiaire d'une résistance $R_2$

et d'un condensateur $C_1$, en D à la photodiode 12. L'émetteur du transistor $T_2$ est relié, par un condensateur $C_2$, à l'entrée d'un amplificateur opérationnel $A_4$ dont la sortie $S_4$ est connectée à un détecteur crête à crête 32. Ce détecteur crête à crête 32 comporte deux diodes en parallèle $D_1$ et $D_2$ reliées chacune à un amplificateur opérationnel à haute impédance d'entrée ($A_5$ et $A_6$) par l'intermédiaire d'un condensateur et d'une résistance montés en parallèle ($C_5$, $R_5$ et $C_6$, $R_6$). Les sorties respectives $S_5$ et $S_6$ des deux amplificateurs $A_5$ et $A_6$ sont directement connectées à l'entrée d'un amplificateur différenciateur $A_7$.

Ainsi, la composante alternative du courant engendré par la photodiode 12 est filtrée par le condensateur $C_1$ et la résistance de charge $R_2$, puis est amplifiée, après passage dans le circuit adaptateur d'impédance 31, par l'amplificateur $A_4$ destiné à porter l'amplitude du signal de modulation à une valeur compatible avec le seuil des diodes $D_1$ et $D_2$ du détecteur crête à crête 32.

La diode $D_1$ et le condensateur $C_5$ détectent la crête ou amplitude positive du signal de modulation présent en $S_4$, et la diode $D_2$ et le condensateur $C_6$ détectent la crête ou amplitude négative de ce signal de modulation. L'amplificateur $A_5$ fournit en sortie $S_5$ l'amplitude positive du signal de modulation, proportionnelle à la puissance optique maximale émise par la diode laser 11, et l'amplificateur $A_6$ fournit en sortie $S_6$ l'amplitude négative du signal de modulation, proportionnelle à la puissance optique minimale de la diode laser 11. Ces tensions positive et négative sont ensuite appliquées à l'amplificateur différenciateur $A_7$ engendrant en $S_7$ une tension proportionnelle à l'amplitude crête à crête du signal de modulation. Cette tension est ensuite intégrée par un filtre passebas 33 de structure classique, puis est présentée à un circuit comparateur de tension 34 constitué d'un amplificateur opérationnel $A_8$ dans lequel elle est comparée à une tension de référence $V_2$. La tension d'erreur engendrée par le comparateur de tension 34 commande un atténuateur variable 35 de structure classique recevant les informations à transmettre présentes à une borne d'entrée E. La sortie $S_8$ de l'atténuateur 35 est reliée à un amplificateur de courant 36 constitué d'un transistor $T_3$ dont la base est reliée à ladite sortie $S_8$ par l'intermédiaire d'un condensateur $C_8$ et dont le collecteur est relié en C à la diode laser 11 par l'intermédiaire d'un condensateur $C_9$. Ainsi, l'atténuateur variable 35 agit sur l'amplitude du courant de modulation généré par le transistor $T_3$, assurant ainsi une stabilisation de l'amplitude de modulation de la puissance optique émise par la diode laser 11.

Du fait de la présence des condensateurs de découplage ($C_1$, $C_2$, $C_9$) dont les valeurs ne doivent pas être trop importantes pour permettre à la fois une hybridation du système et une transmission d'informations à débit élevé, le dispositif de stabilisation de la puissance optique émise qui vient d'être décrit est limité en basse fréquence.

Dans le but de restituer la composante basse fréquence du spectre du signal à transmettre, filtrée par les condensateurs précités, selon l'invention le premier circuit 20 de stabilisation de la valeur moyenne de la puissance optique émise par la diode laser 11 comporte également des moyens de restitution 25 de la composante basse fréquence du signal à transmettre, connectés entre le détecteur crête à crête 32 et le circuit comparateur de tension 23. Plus précisément, ces moyens de restitution 25 sont constitués par un amplificateur opérationnel $A_{10}$ monté en sommateur ayant deux entrées reliées respectivement aux sorties $S_5$ et $S_6$ des deux amplificateurs $A_5$ et $A_6$ du détecteur crête à crête, et une sortie connectée à une entrée $E_9$ de l'amplificateur $A_3$ du circuit comparateur de tension 23. Cet amplificateur sommateur $A_{10}$ constitue des moyens de restitution de la composante basse fréquence du signal à transmettre, destinés à stabiliser les valeurs minimale et maximale de la puissance optique émise par ladite diode laser.

Les deux tensions présentes respectivement aux sorties $S_5$ et $S_6$ des deux amplificateurs $A_5$ et $A_6$, et correspondant aux amplitudes respectives positive et négative du signal de modulation, sont sommées par l'amplificateur opérationnel $A_{10}$. Cet amplificateur $A_{10}$ engendre un signal proportionnel à la composante basse fréquence du signal à transmettre. Ce signal est ensuite appliqué à l'entrée $E_9$ de l'amplificateur $A_3$, et est superposé au signal de polarisation présent à l'entrée $E_3$ dudit amplificateur $A_3$. Dès lors, le transistor $T_1$ génère, par son collecteur, le courant de polarisation superposé à un courant dont l'amplitude est proportionnelle à la composante basse fréquence du signal à transmettre, permettant ainsi d'obtenir une stabilisation des valeurs minimale et maximale de la puissance optique émise par la diode laser 11.

Pour obtenir un fonctionnement correct du dispositif décrit ci-dessus, deux conditions doivent être remplies:

—  la fréquence de coupure liée au condensateur $C_9$ doit être supérieure à la fréquence de coupure associée aux condensateurs $C_5$ et $C_6$; et
—  la fréquence de coupure du dispositif, imposée par $R_5 \cdot C_5$ ou $R_6 \cdot C_6$, doit être supérieure aux fréquences de coupure respectives des filtres passe-bas 22 et 33.

On notera qu'en absence d'informations à l'entrée E du module émetteur, on doit uniquement mettre hors service le circuit 30 de stabilisation de l'amplitude de modulation de la puissance optique.

On a donc réalisé suivant l'invention un dispositif de stabilisation de la puissance optique émise par une diode laser, permettant de restituer la composante basse fréquence du spectre du signal à transmettre, qui est particulièrement simple, très efficace, et avantageux du point de vue du coût de fabrication.

## Revendications

1. Dispositif de stabilisation de la puissance de sortie d'un module émetteur pour un système de transmission d'informations utilisant une fibre optique et comportant:

— un ensemble (10) dans lequel sont disposés une diode laser (11), des moyens de prélèvement (12) d'une partie de la puissance optique émise par la diode laser et de conversion en puissance électrique:

— un premier circuit (20) de stabilisation de la valeur moyenne de la puissance optique émise par la diode laser (11) connecté entre les moyens de conversion (12) et la diode laser (11), et comportant des premiers moyens comparateur de tension (23) engendrant une tension continue stabilisée de polarisation de la diode laser correspondant à la valeur moyenne de la puissance optique émise par la diode laser; et

— un second circuit (30) de stabilisation de l'amplitude de modulation de la puissance optique émise par la diode laser (11) connecté entre les moyens de conversion (12) et la diode laser (11), et comportant des moyens de détection crête à crête (32) du signal de modulation de la diode laser et des moyens de différenciation ($A_7$) des signaux engendrés par les moyens de détection crête à crête fournissant un signal de modulation de la diode laser ayant une amplitude crête à crête stabilisée correspondant à la différence entre la puissance optique maximale et la puissance optique minimale émises par la diode laser; caractérisé en ce que le premier circuit (20) de stabilisation de la valeur moyenne de la puissance optique émise par la diode laser comporte de plus des moyens de restitution (25) de la composante basse fréquence du signal à transmettre connectés entre la sortie des moyens de détection crête à crête (32) et l'entrée des premiers moyens comparateur de tension (23), permettant ainsi de stabiliser les valeurs minimale et maximale de la puissance optique émise par la diode laser.

2. Dispositif selon la revendication 1, caractérisé en ce que les moyens de restitution (25) comportent des moyens de sommation ($A_{10}$) des signaux engendrés par les moyens de détection crête à crête (32), délivrant en sortie une tension dont la valeur assure la restitution de la composante basse fréquence du signal à transmettre, permettant ainsi de stabiliser les valeurs minimale et maximale de la puissance optique émise par la diode laser.

3. Dispositif selon l'une des revendications 1 et 2, caractérisé en ce que les moyens de détection crête à crête (32) comportent deux diodes en parallèle ($D_1$, $D_2$) reliées chacune à l'entrée d'un amplificateur ($A_5$, $A_6$) à haute impédance d'entrée, la sortie de chaque amplificateur étant reliée aux moyens de différenciation ($A_7$) et aux moyens de restitution (25).

4. Dispositif selon l'une des revendications 1 à 3, caractérisé en ce que le second circuit (30) de stabilisation de l'amplitude de modulation de la puissance optique émise par la diode laser comporte de plus:

— des moyens adaptateur d'impédance (31) connectés entre les moyens de conversion (12) et l'entrée des moyens de détection crête à crête (32);

— un premier filtre passe-bas (33) connecté à la sortie des moyens de différenciation ($A_7$);

— des seconds moyens comparateur de tension (34) connectés à la sortie du premier filtre passe-bas (33); et

— un amplificateur de courant (36) commandé par les informations à transmettre et connecté en série entre les seconds moyens comparateur de tension (34) et la diode laser (11).

5. Dispositif selon la revendication 4, caractérisé en ce que le second circuit (30) de stabilisation de l'amplitude de modulation de la puissance optique émise par la diode laser comporte également un atténuateur variable (35) connecté entre les seconds moyens comparateur de tension (34) et l'amplificateur de courant (36), l'atténuateur variable ayant une borne d'entrée recevant les informations à transmettre.

6. Dispositif selon l'une des revendications précédentes, caractérisé en ce que le premier circuit (20) de stabilisation de la valeur moyenne de la puissance optique émise par la diode laser comporte de plus en série:

— un amplificateur opérationnel ($A_1$) monté en transimpédance dont l'entrée est connectée aux moyens de conversion (12); et

— un second filtre passe-bas (22) dont la sortie est connectée aux premiers moyens comparateur de tension (23).

## Patentansprüche

1. Anordnung zur Stabilisierung der Ausgangsleistung eines Sendermoduls für ein eine Glasfaser verwendendes Informationsübertragungssystem

— mit einer Baugruppe (10), in der eine Laserdiode (11), Mittel (12) zur Aufnahme eines Teils der von der Laserdiode ausgehenden optischen Leistung und zur Umwandlung in eine elektrische Leistung vorgesehen sind,

— mit einem ersten Stabilisationskreis (20) für den Mittelwert der von der Laserdiode ausgehenden optischen Leistung, wobei dieser Kreis zwischen den Umwandlungsmitteln (12) und der Laserdiode (11) angeschlossen ist und erste Spannungsvergleichsmittel (23) enthält, die eine stabilisierte Gleichspannung für die Vorspannung der Laserdiode entsprechend dem Mittelwert der von der Laserdiode ausgehenden optischen Leistung erzeugen; und

— mit einem zweiten Stabilisationskreis (30) für die Modulationsamplitude der von der Laserdiode (11) ausgehenden optischen Leistung, wobei dieser Kreis zwischen den Umwandlungsmitteln (12) und der Laserdiode (11) angeschlossen ist und Spitzenwertdetektormittel (32) für das Modulationssignal der Laserdiode sowie Differenziermittel (A₇) für die von den Spitzenwertdetektormitteln erzeugten Signale enthält, welche ein Modulationssignal für die Laserdiode mit einer stabilisierten Spitze-zu-Spitze-Amplitude entsprechend der Differenz zwischen der maximalen und der minimalen optischen von der Laserdiode ausgehenden Leistung liefern,

dadurch gekennzeichnet, daß der erste Stabilisationskreis (20) für den Mittelwert der von der Laserdiode ausgehenden optischen Leistung außerdem Mittel (25) zur Restitution der Niederfrequenzkomponente des zu übertragenden Signals aufweist, die zwischen dem Ausgang der Spitzenwertdetektormittel (32) und dem Eingang der ersten Spannungsvergleichsmittel (23) angeschlossen sind und somit die Stabilisierung der Minimal- und Maximalwerte der von der Laserdiode ausgehenden optischen Leistung erlauben.

2. Anordnung nach Anspruch 1, dadurch gekennzeichnet, daß die Restitutionsmittel (25) Summiermittel (A₁₀) für die von den Spitzenwertdetektormitteln (32) erzeugten Signale aufweisen und ausgangsseitig eine Spannung erzeugen, deren Wert die Restitution der Niederfrequenzkomponente des zu übertragenden Signals sicherstellt, wodurch die Stabilisierung des Minimal- und Maximalwerts der von der Laserdiode ausgehenden optischen Leistung erreicht wird.

3. Anordnung nach einem der Ansprüche 1 und 2, dadurch gekennzeichnet, daß die Spitzenwertdetektormittel (32) zwei zueinander parallele Dioden (D₁, D₂) enthalten, die je an den Eingang eines Verstärkers (A₅, A₆) mit großer Eingangsimpedanz angeschlossen sind, wobei der Ausgang jedes Verstärkers an die Differenziermittel (A₇) und an die Restitutionsmittel (25) angeschlossen ist.

4. Anordnung nach einem der Ansprüche 1 bis 3, dadurch gekennzeichnet, daß der zweite Stabilisationskreis (30) für die Modulationsamplitude der von der Laserdiode ausgehenden optischen Leistung außerdem enthält:

— Impedanzanpassungsmittel (31), die zwischen den Umwandlungsmitteln (12) und dem Eingang der Spitzenwertdetektormittel (32) angeschlossen sind;

— ein erstes Tiefpaßfilter (33), das an den Ausgang der Differenziermittel (A₇) angeschlossen ist;

— zweite Spannungsvergleichsmittel (34), die an den Ausgang des ersten Tiefpaßfilters (33) angeschlossen sind; und

— einen Stromverstärker (36), der von den zu übertragenden Informationen gesteuert wird und in Reihe zwischen den zweiten Spannungsvergleichsmitteln (34) und der Laserdiode (11) angeschlossen ist.

5. Anordnung nach Anspruch 4, dadurch gekennzeichnet, daß der zweite Stabilisationsschaltkreis (30) für die Modulationsamplitude der von der Laserdiode ausgehenden optischen Leistung außerdem ein variables Dämpfungsglied (35) enthält, das zwischen die zweiten Spannungsvergleichsmittel (34) und den Stromverstärker (36) eingefügt ist und über einen Eingang die zu übertragenden Informationen zugeführt erhält.

6. Anordnung nach einem der vorhergehenden Ansprüche, dadurch gekennzeichnet, daß der erste Stabilisationsschaltkreis (20) für den Mittelwert der von der Laserdiode ausgehenden optischen Leistung außerdem in Reihe enthält:

— einen Operationsverstärker (A₁) in einer Transimpedanzanordnung, dessen Eingang an die Umwandlungsmittel (12) angeschlossen ist; und

— ein zweites Tiefpaßfilter (22), dessen Ausgang an die ersten Spannungsvergleichsmittel (23) angeschlossen ist.

**Claims**

1. A device for stabilizing the output power of a transmitter module in a data transmission system which utilizes an optical fiber, and comprising:

— a unit (10) in which are disposed a laser diode (11), means (12) for taking a part of the optical output power emitted by the laser diode and for converting optical power to electrical power,

— a first circuit (20) for stabilizing the mean value of the optical output power emitted by said laser diode (11), said circuit being connected between said conversion means (12) and said laser diode (11) and provided with forst voltage comparator means (23) adapted to produce a laser-diode d. c. bias voltage corresponding to the mean value of the optical output power emitted by said laser diode; and

— a second circuit (30) for stabilizing the modulation amplitude of the optical output power emitted by said laser diode (11), said circuit being connected between the conversion means (12) and said laser diode (11) and provided with means (32) for detecting the peak-to-peak amplitude of the laser-diode modulating signal and means (A₇) for differentiating the signals generated by said peak-to-peak detection means so as to deliver a laser diode modulating signal having a stabilized peak-to-peak amplitude corresponding to the difference between the maximum optical output power and the minimum optical output power emitted by the laser diode, characterized in that the first circuit (20) for stabilizing the mean value of the optical output power emitted by the laser diode is further provided with means (25) for restituting the low-frequency component of the signal to be transmitted, said restituting means being connected between the output of the peak-to-peak detection means (32) and the input of said first voltage comparator means (23), thus permitting stablization of the minimum and maximum values of optical output power emitted by said laser diode.

2. A device according to claim 2, characterized in that the restitution means (25) comprise means $(A_{10})$ for summing the signals generated by the peak-to-peak detection means (32), there being delivered at the output of said restitution means a voltage having a value which ensures restitution of the low-frequency component of the signal to be transmitted and thus permits stabilization of the minimum and maximum values of the optical output power emitted by the laser diode.

3. A device according to one of the claims 1 to 2, characterized in that the peak-to-peak detection means (32) comprise two diodes $(D_1, D_2)$ in paralle each connected to the input of an amplifier $(A_5, A_6)$ having a high input impedance, the output of each amplifier being connected to the differentiation means $(A_7)$ and to said restitution means (25).

4. A device according to one of the claims 1 to 3, characterized in that the second circuit (30) for stabilizing the modulation amplitude of the optical output power emitted by the laser diode further comprises:

— impedance-matching means (31) connected between the conversion means (12) and the input of the peak-to-peak detection means (32);
— a first low-pass filter (33) connected to the output of the differentiating means $(A_7)$;
— second voltage comparator means (34) connected to the output of the first low-pass filter (33); and
— a current amplifier (36) controlled by the informations to be transmitted and connected in series between the second voltage comparator means (34) and the laser diode (11).

5. A device according to claim 4, characterized in that the second circuit (30) for stabilizing the modulation amplitude of the optical output power emitted by the laser diode further comprises a variable attenuator (35) connected between the second voltage comparator means (34) and the current amplifier (36), said variable attenuator being provided with an input terminal for receiving informations to be transmitted.

6. A device according to one of the preceding claims, characterized in that the first circuit (20) for stabilizing the mean value of the optical output power emitted by the laser diode further comprises in series:

— an operational amplifier $(A_1)$ mounted as a transimpedance whose input is connected to said conversion means (12); and
— a second low-pass filter (22) whose output is connected to said forst voltage comparatir means (23).